# EUROPÄISCHE PATENTANMELDUNG

(11) **EP 2 094 071 A2**
(43) Veröffentlichungstag der Anmeldung: **26.08.2009**
(21) Anmeldenummer: 09152427.2
(22) Anmeldetag: 10.02.2009
(51) Int. Cl.: H05K 13/00

(54) **Vorrichtung zum Transportieren von Substraten bei einem Bestückautomaten, Bestückautomat und Verfahren zum Transportieren von Substraten**

(30) Priorität: 21.02.2008 DE 102008010236
(71) Anmelder: Siemens Electronics Assembly Systems GmbH & Co. KG, 81379 München (DE)
(72) Erfinder: Dietrich, Stefan, 76149 Karlsruhe (DE); Stützer, Roland, 589630 Singapore (SG)
(74) Vertreter: Maier, Daniel Oliver

(57) **Zusammenfassung**

Die Vorrichtung (4) zum Transportieren von Substraten (2) bei einem Bestückautomaten (1) umfasst eine Sammelvorrichtung (10) zum Sammeln der Substrate (2) sowie eine erste Transporteinrichtung (11) zum Transport der Substrate (2) zur Sammelvorrichtung (10). Die Sammelvorrichtung (10) weist zumindest eine Anzahl an Abschnitten (12) zur Aufnahme einer zugeordneten Anzahl an Substraten (2) auf, wobei die Abschnitte (12) in einer Transportrichtung (T) der Substrate (2) aufeinanderfolgend angeordnet sind. Dabei können die Substrate (2) mittels der Sammelvorrichtung (10) zueinander in einer relativen Lage und in einem diskreten Raster angeordnet und mittels der ersten Transporteinrichtung (11) weitertransportiert werden, wobei die ursprüngliche relative Lage der Substrate (2) zueinander erhalten bleibt. Mit Hilfe der Vorrichtung (4) können Substrate (2) auf einfache Weise gesammelt werden, um anschließend gemeinsam weitertransportiert zu werden. Da die Substrate (2) beim Sammeln in einem diskreten Raster angeordnet sind und nicht gegeneinander gefahren werden, können sie beim Aufreihen auch nicht aufeinander geschoben werden. Die Prozesssicherheit wird dadurch deutlich erhöht.

## Beschreibung

Die Erfindung betrifft eine Vorrichtung zum Transportieren von Substraten bei einem Bestückautomaten, einen Bestückautomat sowie ein Verfahren zum Transportieren von Substraten.

In der Bestücktechnik werden Substrate, in der Regel Leiterplatten, über eine Transportstrecke mittels einer Transportvorrichtung in einen Bestückbereich eines Bestückautomaten transportiert, wo die Substrate mit Bauelementen bestückt werden. Seitlich der Transportstrecke sind hierfür Zuführvorrichtungen zum Bereitstellen der Bauelemente angeordnet. Ein durch ein Positioniersystem verfahrbarer Bestückkopf holt die Bauelemente von den Zuführvorrichtungen ab, verfährt sie in den Bestückbereich, in dem das zu bestückende Substrat bereitgestellt ist und setzt die Bauelementen auf dem Substrat ab.

Die Transportvorrichtung zum Transport der Substrate sieht dabei in der Regel mehrere Transportbänder als Endlosbänder vor, die parallel zueinander und in Transportrichtung erstreckt angeordnet sind. Auf den jeweiligen Oberflächen der Transportbänder werden die Substrate in den Bestückbereich bzw. aus dem Bestückbereich transportiert. Häufig ist die Transportvorrichtung dreigeteilt in ein so genanntes Eingabeband für den Transport zum Bestückbereich, ein Band im Bestückbereich sowie ein so genanntes Ausgabeband für den Transport aus dem Bestückbereich. Die einzelnen Transportbänder werden dabei so angesteuert, dass die Substrate von einem Transportband an das nächste Transportband übergeben werden. Dieser Aufbau führt jedoch dazu, dass in der Regel nur ein Substrat auf jedem Transportband transportiert werden kann. Speziell bei kleinen Leiterplatten wird dabei der Bestückbereich eines Bestückautomaten nicht optimal ausgenutzt.

Um den Bestückbereich eines Bestückautomaten optimal auszunutzen sind Verfahren zum Bestücken von elektrischen Bauteilen, beispielsweise aus der DE 19962693 A1, bekannt, bei denen zunächst ein erstes Substrat durch ein Eingabeband gegen einen mechanischen Stopper gefahren wird und anschließend ein zweites Substrat gegen das am mechanischen Stopper gestoppte erste Substrat. Die zwei aneinander geschobenen Substrate werden dann gemeinsam in den Bestückbereich transportiert, gemeinsam von einer Klemmeinrichtung geklemmt und anschließend gemeinsam bestückt. Bei dünnen Substraten besteht hierbei jedoch die Gefahr, dass diese beim Aufreihen aufeinander geschoben werden.

Aus der Patentschrift DE 10 2006 025170 B3 ist ferner ein Verfahren zum Transportieren von Substraten in Bestückautomaten bekannt, bei dem eine Speichereinrichtung vorgesehen ist, die sowohl in der Höhe als auch in einer Transportrichtung der Substrate beweglich ist. Mittels dieser beweglichen Speichereinrichtung können mehrere Substrate gesammelt werden, die dann anschließend gemeinsam von der beweglichen Speichereinrichtung in den Bestückbereich des Bestückautomaten transportiert werden. Allerdings ist hierbei zum Verfahren der Speichereinrichtung eine vergleichsweise aufwändige Kinematik erforderlich.

Es ist daher die Aufgabe der vorliegenden Erfindung, ein Verfahren zum Transportieren von Substraten in einem Bestückautomaten, einen Bestückautomaten sowie eine Vorrichtung zum Transport der Substrate bereitzustellen, mittels derer mit geringem Aufwand mehrere Substrate im Bestückbereich des Bestückautomaten bereitgestellt werden können.

Diese Aufgabe wird durch das Transportverfahren, den Bestückautomaten sowie durch die Vorrichtung zum Transport der Substrate gemäß den unabhängigen Ansprüchen gelöst. Vorteilhafte Ausgestaltungen sind Gegenstand der abhängigen Ansprüche.

Die erfindungsgemäße Vorrichtung zum Transportieren von Substraten bei einem Bestückautomaten umfasst eine Sammelvorrichtung, die zum Sammeln der Substrate ausgebildet ist, sowie eine erste Transporteinrichtung, die zum Transport der Substrate zur Sammelvorrichtung ausgebildet ist. Die Sammelvorrichtung weist zumindest eine Anzahl an Abschnitten zur Aufnahme einer zugeordneten Anzahl an Substraten auf, wobei die Abschnitte in einer Transportrichtung der Substrate in diskretem Abstand zueinander aufeinanderfolgend angeordnet sind. Dabei sind die Substrate mittels der Sammelvorrichtung zueinander in einer relativen Lage und in einem diskreten Raster anordenbar und mittels der ersten Transporteinrichtung weitertransportierbar, wobei die ursprüngliche relative Lage der Substrate zueinander erhalten bleibt.

Die offenbarte Vorrichtung stellt eine einfach zu realisierende Alternative dar, um Substrate zu sammeln, um sie dann gemeinsam weiter zu transportieren. Da die Substrate beim Sammeln in einem diskreten Raster angeordnet sind und nicht gegeneinander gefahren werden, können sie beim Aufreihen auch nicht aufeinander geschoben werden. Die Prozesssicherheit wird dadurch deutlich erhöht.

In einer weiteren vorteilhaften Weiterbildung weist die erste Transporteinrichtung mindestens einen Transportriemen auf, welcher zum Transport der Substrate ausgebildet ist.

Die Verwendung von Transportriemen zum Bewegen von Objekten im Fertigungsumfeld ist einfach und kostengünstig. Prinzipiell ist es auch möglich, die Substrate auf einem einzelnen, breiten Transportriemen liegend zu transportieren. In der Praxis hat es sich jedoch durchgesetzt, zwei schmale Transportriemen zu verwenden, welche in einer Transportebene vorzugsweise parallel nebeneinander bzw. parallel zur Transportrichtung der Substrate angeordnet sind und auf denen die Substrate in ihren Randbereichen aufliegen. Anstelle von Riemen ist es ebenso möglich, andere Transportelemente - beispielsweise Transportketten - zu verwenden.

In einer vorteilhaften Weiterbildung der Vorrichtung ist jeder Abschnitt genau einem Substrat eindeutig zugeordnet.

Indem jeder Abschnitt nur ein Substrat aufnimmt, ist die Position eines jeden Substrats eindeutig definiert. Die Bestückgenauigkeit kann dadurch erhöht werden.

In einer vorteilhaften Weiterbildung der Vorrichtung ist jedem der Abschnitte eine Stoppeinrichtung zugeordnet, mittels derer die Substrate an einer jeweils vordefinierten Stoppposition positionierbar sind.

Mit Hilfe der Stoppeinrichtung kann die Stoppposition des Substrats und damit die spätere Position des Substrats im Bestückbereich sehr genau vorab festgelegt werden. Hieraus ergeben sich Zeitgewinne im weiteren Bearbeitungsprozess, beispielsweise bei der Vermessung der Bezugsmarken der Substrate sowie hinsichtlich der Verfahrwege des Bestückkopfs beim Positionieren der Bauelemente. Ferner kann die Stabilität des Bestückprozesses dadurch erhöht werden.

In einer weiteren Ausgestaltung der Vorrichtung weist jeder Abschnitt eine zweite Transporteinrichtung auf, die mit der ersten Transporteinrichtung derart zusammenwirkt, dass durch die zweite Transporteinrichtung die Substrate von der ersten Transporteinrichtung abnehmbar und in einen Speicherbereich transportierbar sind. Die zweiten Transporteinrichtungen sind dabei derart ausgebildet, dass eine vorgegebene Anzahl gespeicherter Substrate aus dem Speicherbereich auf die erste Transporteinrichtung rückführbar sind, um gemeinsam weitertransportiert zu werden.

Die Sammelvorrichtung weist zur Aufnahme von Substraten eine Anzahl die Abschnitte bildender Segmente auf, mittels derer Substrate von der ersten Transporteinrichtung entkoppelt und in einen Speicherbereich transferiert werden können. Hieraus ergibt sich der Vorteil, dass die erste Transporteinrichtung völlig unabhängig von den gestoppten Substraten betrieben werden kann. Die Flexibilität der ersten Transporteinrichtung wird dadurch deutlich erhöht. Prinzipiell ist auch die Verwendung von nur einem Segment möglich, wenn beispielsweise nur ein einzelnes Substrat gespeichert werden soll. Die Anzahl sowie die Dimensionierung der Segmente sind dabei stark von den Abmessungen der zu bestückenden Substrate abhängig.

In einer vorteilhaften Weiterbildung der Vorrichtung ist die zweite Transporteinrichtung zur geradlinigen Bewegung längs einer Achse ausgebildet.

Eine einfache Linearbewegung der zweiten Transporteinrichtung längs einer Achse ist mit geringem konstruktivem Aufwand realisierbar. Damit stellt diese Ausgestaltung der zweiten Transporteinrichtung zum Entkoppeln des Substrats von der ersten Transporteinrichtung sowie zum Verbringen des Substrats in eine Speicherposition eine einfache und kostengünstige Lösung dar.

In einer weiteren vorteilhaften Weiterbildung ist die zweite Transporteinrichtung als mindestens ein Hubblech ausgebildet, welches derart mit der ersten Transporteinrichtung zusammenwirkt, dass Substrate in den Speicherbereich verbringbar sind.

Ein Hubblech stellt ein einfaches Konstruktionselement dar, welches in einer z-Richtung senkrecht zur Transportebene verfahrbar ist. Zum Entkoppeln eines Substrats von der ersten Transporteinrichtung kann das Hubblech von unten gegen das Substrat gefahren werden, so dass dieses von den Riemen der ersten Transporteinrichtung abgehoben wird. Dabei erfolgt der Kontakt zwischen Hubblech und Substrat vorteilhafter Weise an den seitlichen Randbereichen des Substrats über eine größere Länge, die mindestens der Hälfte der Länge des Substrats entspricht. Dadurch kann ein sicheres Abheben des Substrats von der ersten Transporteinrichtung gewährleistet werden.

In einer weiteren vorteilhaften Weiterbildung sind die zweiten Transporteinrichtungen mehrerer Abschnitte hinsichtlich ihres Bewegungsablaufs gekoppelt und gemeinsam einem Substrat eindeutig zugeordnet.

Durch die variable Zuordnung der die Abschnitte bildenden Segmente bzw. derer zweiten Transporteinrichtungen zu den Substraten kann eine höhere Flexibilität hinsichtlich der Anpassung der Speichervorrichtung an die Größe der jeweiligen Substrate erreicht werden. Beispielsweise ist es möglich, größere Substrate zu speichern, deren Länge die Länge eines einzelnen Segments übersteigt, indem zwei oder mehrere benachbarte Segmente gemeinsam genutzt werden, um das betreffende Substrat in den Speicherbereich zu transferieren.

In einer weiteren vorteilhaften Weiterbildung weist die Vorrichtung mindestens eine Stoppeinrichtung auf, mittels derer das Substrat vor dem Abnehmen des Substrats von der ersten Transporteinrichtung an einer vordefinierten Stoppposition positionierbar ist.

Mit Hilfe der Stoppeinrichtung kann die Stoppposition des Substrats und damit die spätere Position des Substrats im Bestückbereich sehr genau vorab festgelegt werden. Hieraus ergeben sich Zeitgewinne im weiteren Bearbeitungsprozess, beispielsweise bei der Vermessung der Bezugsmarken der Substrate sowie hinsichtlich der Verfahrwege des Bestückkopfs beim Positionieren der Bauelemente. Ferner kann die Stabilität des Bestückprozesses dadurch erhöht werden.

In einer weiteren vorteilhaften Weiterbildung ist die mindestens eine Stoppeinrichtung als mindestens ein mechanischer Stopper ausgebildet.

Bei einem mechanischen Stopper handelt es sich um eine einfache und kostengünstige Möglichkeit zur Realisierung der Stoppeinrichtung. Der mechanische Stopper kann beispielsweise als Finger oder Vorsprung ausgebildet sein, welcher über eine einfache Bewegung von unten oder von der Seite in die erste Transporteinrichtung eingeschoben wird, um die Substrate an einer vordefinierten Position anzuhalten.

In einer weiteren vorteilhaften Weiterbildung ist die zweite Transporteinrichtung eines Abschnitts als mechanischer Stopper für den in Transportrichtung vorgelagerten Abschnitt einsetzbar.

Die Sammelvorrichtung weist eine Anzahl von Abschnitten auf, die in Transportrichtung nacheinander angeordnet sind und jeweils über eine zweite Transporteinrichtung verfügen, mittels derer Substrate von der ersten Transporteinrichtung abgenommen und in einen Speicherbereich transferiert werden können. Befindet sich ein Substrat im Speicherbereich, so kann mittels eines mechanischen Anschlags an der zugeordneten zweiten Transporteinrichtung der Transport eines nachfolgenden Substrats in dieser Position der zweiten Transporteinrichtung behindert werden. Die zweite Transporteinrichtung eines in Transportrichtung nachfolgend angeordneten Abschnitts fungiert somit als mechanischer Stopper für das zeitlich nachfolgende Substrat. Wird das Substrat wieder aus dem Speicherbereich zurück in den Transportbereich verfahren, so wird damit auch der mechanische Anschlag wieder zurück verfahren. Der Transport des nachfolgenden Substrats ist somit wieder freigegeben. Durch eine derartige Gestaltung der zweiten Transporteinrichtung kann auf einen zusätzlichen mechanischen Stopper verzichtet werden.

In einer weiteren vorteilhaften Weiterbildung ist die Stoppeinrichtung als Sensor ausgebildet, welcher ein Substrat registriert und mit einer Steuereinheit der Vorrichtung gekoppelt ist, so dass die erste Transporteinrichtung derart steuerbar ist, dass das Substrat an der vordefinierten Stopp-position positionierbar ist.

Durch die Verwendung eines Sensors ergibt sich der Vorteil, dass die Stoppposition flexibel festgelegt werden kann, ohne dass hierzu Anpassungen an der Mechanik der Vorrichtung notwendig sind. Registriert der Sensor ein Substrat, so kann über die Restlaufzeit sowie die Transportgeschwindigkeit der ersten Transporteinrichtung eine Stoppposition des Substrats flexibel bestimmt oder variiert werden.

In einer weiteren vorteilhaften Weiterbildung der Vorrichtung ist in Transportrichtung nach der Sammeleinrichtung ein Bestückbereich angeordnet, in den die Substrate nach dem Sammeln gemeinsam transportiert werden.

Die Substrate nehmen durch das Stoppen definierte Positionen ein, aus denen definierte Lagebeziehungen der einzelnen Substrate zueinander resultieren. Da diese Lagebeziehungen auch beim Weitertransport nicht mehr verändert werden, nehmen die Substrate auch im Bestückbereich des Bestückautomaten dieselbe relative Lage zueinander ein. Hieraus ergeben sich Zeitgewinne im weiteren Bearbeitungsprozess, beispielsweise bei der Vermessung der Bezugsmarken der Substrate sowie hinsichtlich der Verfahrwege des Bestückkopfs beim Positionieren der Bauelemente. Ferner kann die Stabilität des Bestückprozesses dadurch erhöht werden.

In einer weiteren vorteilhaften Weiterbildung sind im Bestückbereich befindliche Substrate mit Bauelementen bestückbar, während weitere Substrate transportiert und vor dem Bestückbereich mittels der Sammelvorrichtung gesammelt werden.

Mit Hilfe der Vorrichtung ist es möglich, die Tätigkeiten "Bestücken der Substrate mit Bauelementen" und "Sammeln von Substraten vor dem Bestückbereich" voneinander zu entkoppeln, so dass sie völlig unabhängig voneinander ablaufen können. Dadurch können die Prozesszeiten der beiden Teilprozesse parallelisiert werden, wodurch eine deutlich höhere Bestückleistung realisierbar ist.

Der erfindungsgemäße Bestückautomat zum Bestücken von Substraten mit Bauelementen weist eine Vorrichtung zum Transportieren der Substrate sowie einen Bestückbereich, in dem die Substrate bestückt werden, auf, wobei die Vorrichtung in einer Transportrichtung der Substrate zumindest teilweise vor dem Bestückbereich angeordnet ist.

Insbesondere bei kleineren Substraten ist es vorteilhaft, mehrere Substrate zu einem sogenannten Bestückinhalt zusammenzufassen und gemeinsam zu bestücken. Während der Bestückung von Substraten im Bestückbereich werden weitere Substrate vor dem Bestückbereich gesammelt und zu einem Bestückinhalt zusammengefasst. Hierdurch kann die Substrat-Wechselzeit zwischen zwei Bestückungsvorgängen verkürzt werden, wodurch sich die Bestückleistung deutlich erhöht. Hinsichtlich weiterer Vorteile des erfindungsgemäßen Bestückautomaten mit einer Vorrichtung nach einem der vorhergehenden Ansprüche wird auf die Ausführungen zu den obigen Ansprüchen verwiesen.

In einer vorteilhaften Weiterbildung weist der Bestückautomat mehrere Bestückbereiche auf, wobei auch zwischen den Bestückbereichen eine Vorrichtung zum Transportieren der Substrate vorgesehen ist.

Für Bestückautomaten, die mehrere Bestückbereiche in einer Transportrichtung der Substrate hintereinander folgend aufweisen, ist es zur Verkürzung der Substrat-Wechselzeiten zweckmäßig, die Substrate vor jedem Bestückbereich zu sammeln und zu einem Bestückinhalt zusammengefasst in den jeweiligen Bestückbereich zu transferieren.

Bei dem erfindungsgemäßen Verfahren zum Transportieren von Substraten bei einem Bestückautomaten werden in einem ersten Verfahrensschritt Substrate mittels einer ersten Transporteinrichtung zu einer Sammelvorrichtung transportiert. In einem zweiten Verfahrensschritt werden die Substrate an vordefinierten Positionen eines Transportbereichs, welche in diskretem Abstand zueinander angeordnet sind, gestoppt, so dass die Substrate eine definierte, relative Lage zueinander aufweisen. In einem dritten Verfahrensschritt wird eine vorbestimmte Anzahl an gespeicherten Substraten mittels der ersten Transporteinrichtung aus dem Transportbereich in einen Bestückbereich weitertransportiert, wobei die ursprüngliche relative Lage der Substrate zueinander erhalten bleibt.

Mit Hilfe des erfindungsgemäßen Verfahrens können ein oder mehrere Substrate vor dem Bestückbereich gesammelt werden, während zumindest ein weiteres Substrat transportiert und an einer vordefinierten Position gestoppt werden kann. Die Substrate werden dabei in eine definierte Lage zueinander gebracht, die auch beim nachfolgenden Weitertransport beibehalten wird. Das Zusammenfassen mehrerer Substrate ist für die weiteren Prozessschritte insbesondere bei kleineren Substraten vorteilhaft. Nachteile, wie beispielsweise das Aufeinanderschieben von Substraten, wenn ein erstes Substrat gestoppt wird und anschließend ein zweites Substrat gegen das gestoppte erste Substrat geschoben wird, werden vermieden.

In einer vorteilhaften Weiterbildung des Verfahrens werden die Substrate vor dem Weitertransport der Substrate in den Bestückbereich in einen Speicherbereich verbracht und dort gesammelt. Anschließend werden die gespeicherten Substrate aus dem Speicherbereich wieder in den Transportbereich gebracht.

Hieraus ergibt sich der Vorteil, dass diejenigen Substrate, welche bereits an ihren vordefinierten Positionen gestoppt wurden, während des weiteren Sammelvorgangs von der ersten Transporteinrichtung entkoppelt werden. Die Flexibilität der ersten Transporteinrichtung wird dadurch deutlich erhöht. Vor dem Weitertransport in den Bestückbereich werden dann die im Speicherbereich gespeicherten Substrate exakt an ihren vordefinierten Stopppositionen wieder in Kontakt mit der ersten Transporteinrichtung gebracht, so dass sie in der vorbestimmten, relativen Lage zueinander in den Bestückbereich weitertransportiert werden.

In einer vorteilhaften Weiterbildung des Verfahrens wird vor dem Weitertransport der Substrate in den Bestückbereich ein weiteres Substrat im Transportbereich an einer weiteren Position gestoppt, so dass die Substrate aus dem Speicherbereich zusammen mit dem weiteren Substrat gemeinsam weitertransportiert werden.

Hierbei ergibt sich der Vorteil, dass das letzte Substrat nicht erst aus dem Transportbereich in den Speicherbereich verfahren werden muss, um dann wieder gemeinsam mit den restlichen gespeicherten Substraten wieder aus dem Speicherbereich in den Transportbereich gebracht zu werden. Daraus lässt sich ein Zeitgewinn erzielen, wodurch die Effizienz des Transportprozesses erhöht werden kann. Ferner ist ein Teil der Vorrichtung zum Verbringen des Substrats vom Transportbereich in den Speicherbereich entbehrlich, wodurch die Herstellkosten der Vorrichtung reduziert werden können.

In einer weiteren vorteilhaften Weiterbildung werden die n Substrate mit Hilfe zugeordneter, die Abschnitte bildender Segmente, die in einer Substrat-Transportrichtung aufeinander folgen, durch eine Hubbewegung aus dem Transportbereich in den Speicherbereich gebracht.

Bei einer Hubbewegung handelt es sich um eine mechanisch einfach zu realisierende, weil lineare Bewegungsform. Vorteilhafter Weise handelt es sich dabei um eine ausschließliche Hubbewegung, die lediglich einen zur Substrat-Transportrichtung senkrechten Bewegungsanteil aufweist.

In einer weiteren vorteilhaften Weiterbildung des Verfahrens wird jedes der Substrate mit jeweils einem zugeordneten Segment transportiert.

Jedes Substrat wird an einer eigenen vordefinierten Position im Transportbereich gestoppt und mittels eines eindeutig zugeordneten Segments durch eine definierte Hubbewegung vom Transportbereich in den Speicherbereich verfahren. Mittels einer Absenkbewegung des Segments wird jedes der Substrate wieder zurück in den Transportbereich verfahren. Durch diese Bewegungsabfolge wird sichergestellt, dass die absolute Lageposition eines jeden Substrats sowie die relative Lage zu den weiteren Substraten zu jedem Zeitpunkt eindeutig definiert sind.

In einer weiteren vorteilhaften Weiterbildung erfolgt ein Bewegungsablauf mehrerer Segmente gekoppelt, um ein Substrat aus dem Transportbereich in den Speicherbereich zu bringen.

Segmente einer Sammeleinrichtung weisen in Transportrichtung ein bestimmtes Rastermaß auf. Substrate, deren Länge kürzer ist als diese Rastermaß, können mittels des ihnen zugeordneten Segments aus dem Transportbereich in den Speicherbereich transferiert werden. Da Bestückautomaten für verschiedene Substrattypen flexibel einsetzbar sein sollen, kann es erforderlich sein, die Speichereinrichtung hinsichtlich der Länge ihrer Segmente auf ein neu zu rüstendes Los von Substraten anzupassen. Prinzipiell wäre es möglich, die Segmente auszutauschen oder hinsichtlich ihrer Länge anpassbar zu gestalten. Damit ist jedoch ein nicht unerheblicher Aufwand sowohl konstruktiver und finanzieller als auch zeitlicher Art verbunden.

Indem mehrere benachbarte Segmente hinsichtlich ihres Bewegungsablaufs zu einem Verbund gekoppelt werden, kann auch ein Substrat mit einer Länge größer als das Rastermaß der Segmente problemlos in den Speicherbereich transferiert werden, ohne dass hierzu umfangreiche Anpassungen vorzunehmen sind. Die Flexibilität des Bestückautomaten kann dadurch insbesondere bei kleinen Losgrößen deutlich erhöht werden.

In einer weiteren vorteilhaften Weiterbildung des Verfahrens werden die Substrate gemeinsam in einen Bestückbereich eines Bestückautomaten transportiert, um dort mit Bauelementen bestückt zu werden, wobei während der Bestückung der Substrate weitere Substrate vor dem Bestückbereich gesammelt werden.

Durch das zumindest teilweise Parallelisieren der Tätigkeiten "Bestücken der Substrate mit Bauelementen" und "Sammeln von Substraten vor dem Bestückbereich" können transportbedingte Wartezeiten verkürzt werden, wodurch eine deutlich höhere Bestückleistung realisiert werden kann.

Im Folgenden werden Ausführungsbeispiele der erfindungsgemäßen Vorrichtung unter Bezug auf die beigefügten Figuren näher erläutert. Dabei zeigt:
- Figur 1: eine schematische Darstellung eines Bestückautomaten im Grundriss,
- Figuren 2A und 2B: schematische Schnittdarstellungen durch ein Segment der Sammelvorrichtung im Aufriss, und
- Figuren 3A bis 3L: schematische Seitenansichten der erfindungsgemäßen Vorrichtung in mehreren Verfahrensschritten.
- Figuren 4A bis 4H: schematische Seitenansichten einer weiteren Ausbildung der erfindungsgemäßen Vorrichtung in mehreren Verfahrensschritten

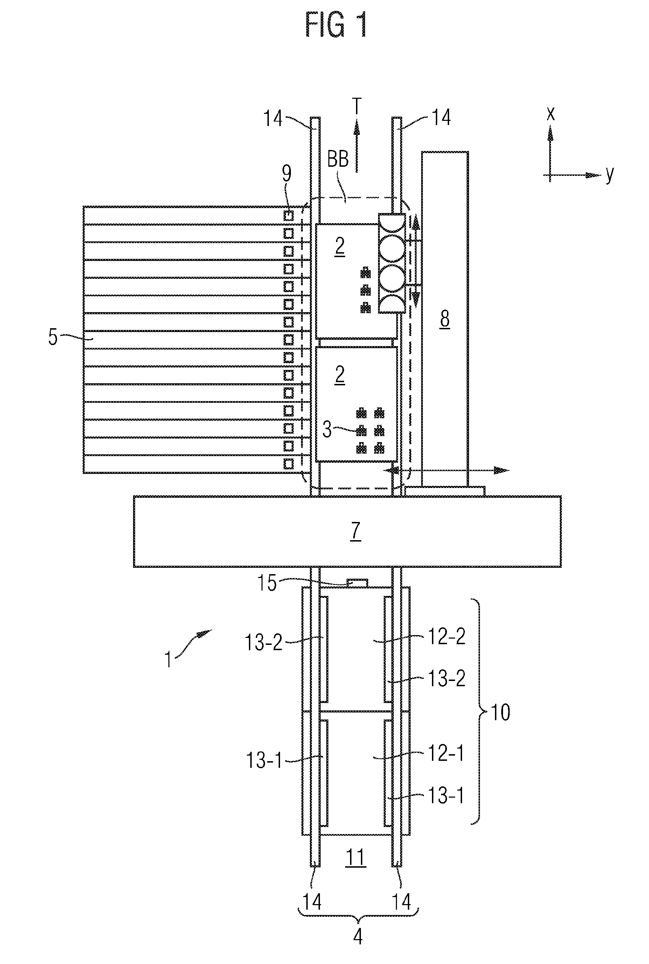

Figur 1 zeigt schematisch einen Bestückautomat 1 zum Bestücken von Substraten 2 mit Bauelementen 3. Der Bestückautomat 1 besteht aus einem Querträger 7, welcher sich in einer y-Richtung erstreckt und fest mit einem Maschinengestell (nicht dargestellt) verbunden ist. Am Querträger 7 ist ein Portalarm 8 angebracht, welcher sich in x-Richtung erstreckt und in y-Richtung verschiebbar am Querträger 7 befestigt ist. Der Portalarm 8 bildet zusammen mit dem Querträger 7 eine Positioniervorrichtung, wobei durch die x-Achse und die y-Achse ein orthogonales Bezugsystem gebildet wird. Am Portalarm 8 ist der Bestückkopf 6 in x-Richtung verschiebbar angeordnet.

Weiterhin ist eine Vorrichtung 4 zum Transport der Substrate 2 in einer Transportrichtung T vorgesehen, welche sich ebenfalls in x-Richtung erstreckt. Seitlich der Transportvorrichtung 4 sind in der Nähe des Bestückbereichs BB Zuführvorrichtungen 5 angeordnet, welche die Bauelemente 3 an Abholpositionen 9 bereitstellen. Die von den Zuführvorrichtungen 5 bereitgestellten Bauelemente 3 werden durch den Bestückkopf 6 abgeholt und auf einem im Bestückbereich BB positionierten Substrat 2 abgesetzt. Fertig bestückte Substrate 2 werden mit Hilfe der Vorrichtung 4 wieder aus dem Bestückbereich BB heraustransportiert.

Mit Hilfe der Vorrichtung 4 können die Substrate 2 in x-Richtung in den Bestückbereich BB des Bestückautomaten 1 transportiert werden. Hierzu verfügt die Vorrichtung 4 über eine erste Transporteinrichtung 11 mit zwei steuerbaren Transportriemen 14, auf denen die Substrate 2 in ihren Randbereichen aufliegen.

Ferner weist die Vorrichtung 4 eine Sammelvorrichtung 10 zum Sammeln der Substrate 2 auf, welche in Transportrichtung T vor dem Bestückbereich BB angeordnet ist. Die Sammelvorrichtung 10 besteht aus mehreren Abschnitten 12-1, 12-2, welche von Segmenten 12-1, 12-2 gebildet werden und die in Transportrichtung T aufeinanderfolgend angeordnet sind. Jedes der Segmente 12-1, 12-2 verfügt über eine zweite Transporteinrichtung 13-1 bzw. 13-2, welche in einer z-Richtung quer zur Transportrichtung T verfahrbar am jeweiligen Segment 12-1 bzw. 12-2 angeordnet ist. Mit Hilfe der zweiten Transporteinrichtungen 13 können Substrate 2 von den Transportriemen 14 abgehoben, in einen Speicherbereich oberhalb der Transportriemen 14 verfahren und wieder zurück auf die Transportriemen 14 gesetzt werden. Zwischen der Sammelvorrichtung 10 und dem Bestückbereich BB ist eine Stoppeinrichtung 15 zum Stoppen des ersten ankommenden Substrats (2) angeordnet.

Mit Hilfe der Vorrichtung 4 ist es möglich, mehrere Substrate 2 vor dem Bestückbereich BB des Bestückautomaten 1 zu sammeln, wobei die mehreren Substrate 2 eine definierte, relative Lage zueinander einnehmen, die auch beim gemeinsamen Weitertransport der mehreren Substrate 2 in den Bestückbereich BB erhalten bleibt. Anstelle der zweiten Transporteinrichtungen 13 können die Abschnitte 12 der Sammelvorrichtung 10 auch mit Stoppeinrichtungen 15 versehen werden. Die Stoppeinrichtungen 15 sind in diskretem Abstand zueinander angeordnet und stoppen die mittels der ersten Transporteinrichtung 11 transportierten Substrate 2 ebenfalls an vordefinierten Positionen vor dem Bestückbereich BB. Dabei werden die Substrate 2 jedoch nicht von der ersten Transporteinrichtung 11 entkoppelt, sondern verbleiben auf den Transportriemen 14. Beim Transport eines weiteren Substrats 2 zur Sammelvorrichtung schleifen die Transportriemen 14 unter den bereits an ihren definierten Positionen gestoppten Substraten 2 hindurch, wobei diese gegen die zugeordneten Stoppeinrichtungen 15 gedrückt werden. Die Lage der bereits gestoppten Substrate wird dabei nicht verändert.

Die Substrat-Transportvorrichtung ist in Figur 1 einspurige ausgeführt. Es ist jedoch selbstverständlich ebenso möglich, eine zwei- oder mehrspurige Substrat-Transportvorrichtung gemäß der vorliegenden Erfindung zu gestalten und beispielsweise die erfindungsgemäße Sammelvorrichtung 10 für alle Transportspuren vorzusehen. Ebenso ist es bei Bestückautomaten mit mehreren hintereinander angeordneten Bestückbereichen möglich, die erfindungsgemäße Vorrichtung 4 vor jedem der Bestückbereiche anzuordnen.

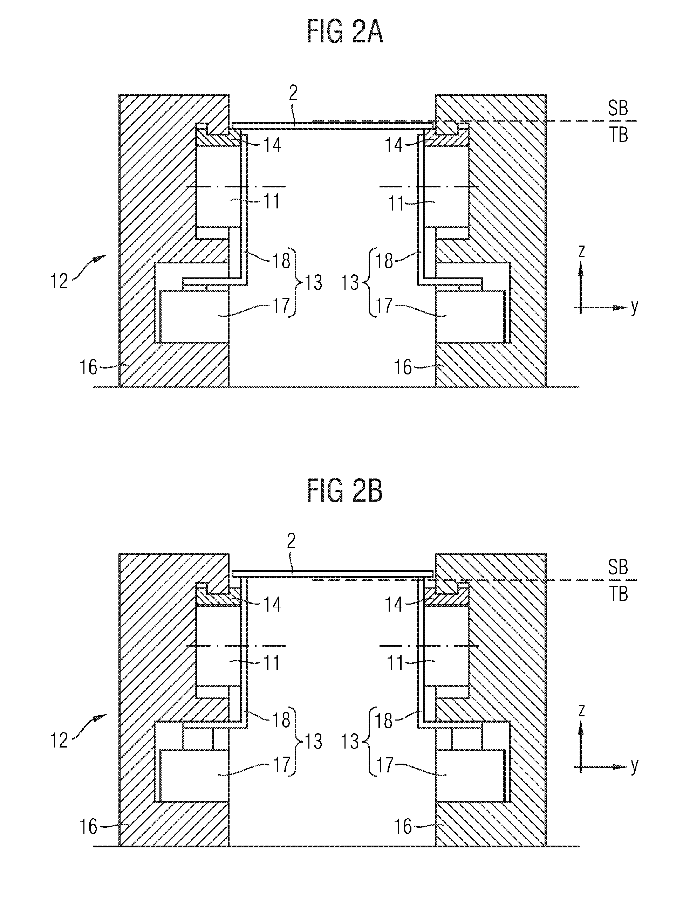

Die Figuren 2A und 2B stellen schematische Schnittdarstellungen durch ein Segment 12 der Sammelvorrichtung 10 im Aufriss dar.

Figur 2A zeigt ein Segment 12 der Sammelvorrichtung 10, bei dem sich ein Substrat 2 im Transportbereich TB der Vorrichtung 4 befindet. Zum Transport des Substrats 2 in einer x-Richtung liegt das Substrat 2 an seinen Randbereichen auf Transportriemen 14 auf. Die beiden Transportriemen 14 gehören zu einer ersten Transporteinrichtung 11, welche in den Figuren 2A und 2B als umlaufende Transportriemen 14 ausgebildet sind. Die zweite Transporteinrichtung 13 zum Abheben der Substrate 2 von den Riemen 14 der ersten Transporteinrichtung 11 ist in den Figuren 2A und 2B als bewegliche Hubbleche 18 ausgeführt. Mit Hilfe eines zugeordneten Antriebs 17 kann jedes der Hubbleche 18 in einer z-Richtung verfahren werden. Sowohl die erste Transporteinrichtung 11 als auch die zweite Transporteinrichtung 13 ist seitlich an den beiden Seitenwangen 16 des Segments 12 befestigt.

In Figur 2B ist dasselbe Segment 12 wie in Figur 2A dargestellt, wobei das Substrat 2 von den beiden Transportriemen 14 der ersten Transporteinrichtung 11 entkoppelt ist und sich im Speicherbereich SB der Vorrichtung 4 befindet. Dabei liegt das Substrat 2 in seinen Randbereichen auf den beiden Hubblechen 18 der zweiten Transporteinrichtung 13 auf. Die beiden Hubbleche 18 sind mit Hilfe der beiden zugeordneten Antriebe 17 der zweiten Transporteinrichtung 13 in ihre obere Position verfahren. Da das Substrat 2 von den Transportriemen 14 entkoppelt ist, können weitere Substrate 2 mittels der Transportriemen 14 in x-Richtung transportiert werden, ohne dass dadurch die Position des entkoppelten Substrats 2 beeinflusst wird.

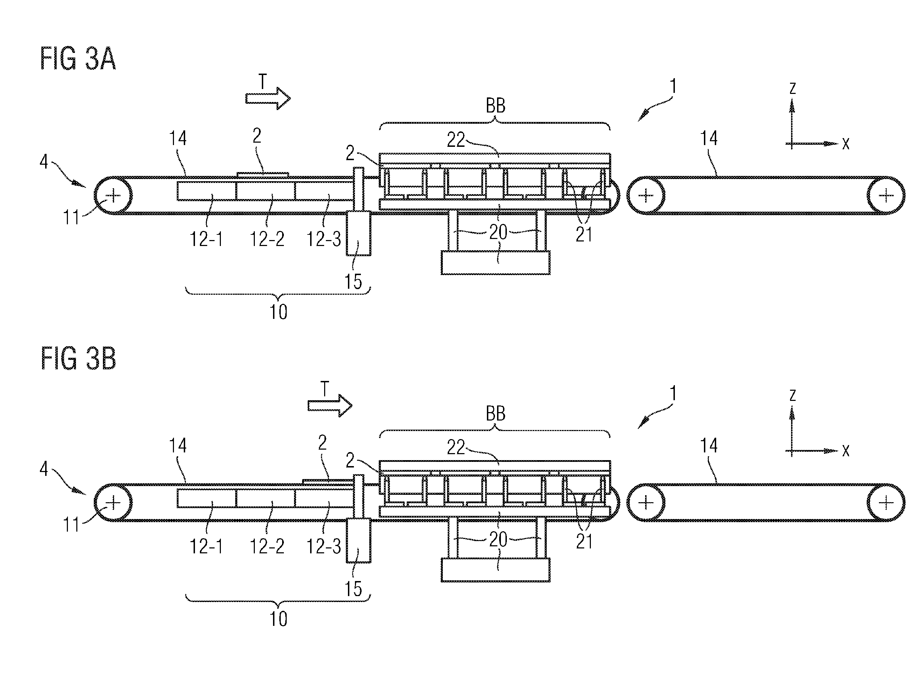

Die Figuren 3A bis 3L zeigen schematisch eine Seitenansicht der erfindungsgemäßen Vorrichtung 4 in mehreren Verfahrensschritten.

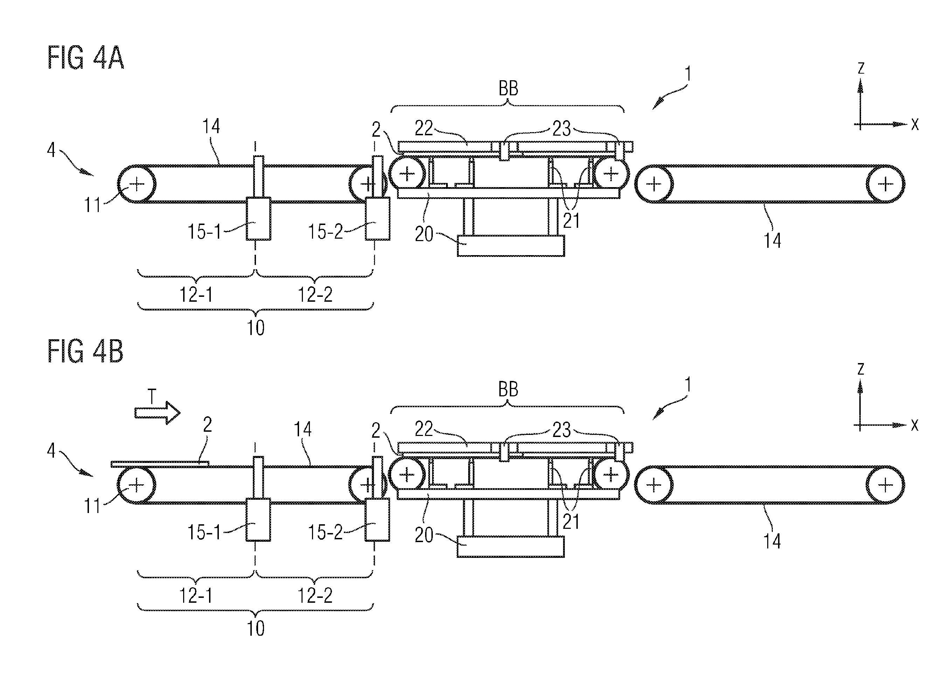

In Figur 3A ist die Vorrichtung 4 zum Transport der Substrate 2 in einer Seitenansicht dargestellt. Die Vorrichtung 4 weist eine erste Transporteinrichtung 11 auf, mittels derer die Substrate 2 in einer Transportrichtung T, welche sich in x-Richtung erstreckt, transportiert werden können. Die erste Transporteinrichtung 11 weist mehrere Transportriemen 14 auf, auf denen die Substrate 2 in ihren Randbereichen aufliegen. Die Transportriemen 14 bilden mehrere Endlosbänder, welche über Umlenkrollen geführt sind. In den Figuren 3A bis 3L sind zwei solcher Endlosbänder in Transportrichtung T aufeinander folgend dargestellt. Es ist jedoch ebenfalls möglich, die erste Transporteinrichtung 11 als mehrere in Transportrichtung T aufeinander folgende Endlosbänder auszugestalten, beispielsweise in dreiteiliger Form (vgl. Figuren 4A bis 4H) mit einem Eingabeband vor dem Bestückbereich BB, einem Band im Bestückbereich BB sowie einem nachgelagerten Ausgabeband zum Abtransport bestückter Substrate 2. Weiterhin kann die erste Transporteinrichtung 11 auch als ein durchgängiges Endlosband ausgebildet sein.

Mit Hilfe der ersten Transporteinrichtung 11 können die Substrate 2 zu einer Sammelvorrichtung 10 und weiter in einen Bestückbereich 22 eines Bestückautomaten 1 transportiert werden. Nachdem die Substrate 2 im Bestückbereich 22 mit Bauelementen 3 (siehe Figur 1) bestückt wurden, werden sie mit Hilfe der ersten Transporteinrichtung 11 wieder aus dem Bestückbereich heraustransportiert. In der Transportrichtung T der Substrate ist vor dem Bestückbereich 22 die Sammelvorrichtung 10 angeordnet, welche aus mehreren Segmenten 12-1, 12-2 und 12-3 besteht. Ferner weist die Sammelvorrichtung 10 noch eine Stopp-Einrichtung 15 zum Stoppen der Substrate in einer definierten Position auf. Mit Hilfe der Segmente 12 kann ein Substrat 2 mittels einer zweiten Transporteinrichtung 13 (siehe Figuren 2A und 2B) von der ersten Transporteinrichtung 11 abgehoben und in einen Speicherbereich SB transferiert werden.

Im Bestückbereich 22 des Bestückautomaten 1 sind mehrere Stützstifte 21 zum Unterstützen der Substrate 2 während des Bestückens mit Bauelementen 3 angeordnet. Die Stützstifte 21 sind zu diesem Zweck auf einem Hubtisch 20 positioniert, welcher in einer z-Richtung verfahren werden kann. Wird der Hubtisch 20 mit den darauf angeordneten Stützstiften 21 in z-Richtung nach oben verfahren, so drücken die Stützstifte von unten gegen die Substrate 2 und heben diese von den Transportriemen 14 der ersten Transporteinrichtung 11 ab. Dabei werden die Substrate 2 gegen oberhalb der Transportriemen 14 angeordnete Klemmelemente 22 gedrückt und dabei fixiert.

Anhand der Figurenfolge 3A bis 3L wird im Folgenden das erfindungsgemäße Verfahren näher erläutert:

In Figur 3A wird mit Hilfe der ersten Transporteinrichtung 11 ein Substrat 2 in Transportrichtung T transportiert. Ein Stopper 15 ist ausgefahren und ragt von unten fingerartig in die Transportspur der ersten Transporteinrichtung 11, so dass ein ankommendes Substrat an dieser Position gestoppt werden kann. Im Bestückbereich BB des Bestückautomaten 1 befinden sich vier Substrate 2, welche mit Bauelementen 3 (nicht dargestellt) bestückt werden. Um eine hohe Bestückgenauigkeit während des Bestückvorgangs zu gewährleisten, werden die Substrate 2 im Bestückbereich BB mit Hilfe des Hubtisches 20 und der Stützstifte 21 von unten gegen das Klemmelement 22 gedrückt und dadurch fixiert.

In Figur 3B wurde das Substrat 2 mittels des Stoppers 15 gestoppt und befindet sich nun oberhalb des in Transportrichtung T letzten Segments 12-3 der Sammelvorrichtung 10. Im Bestückbereich BB werden die dort fixierten Substrate 2 weiterhin mit Bauelementen 3 bestückt.

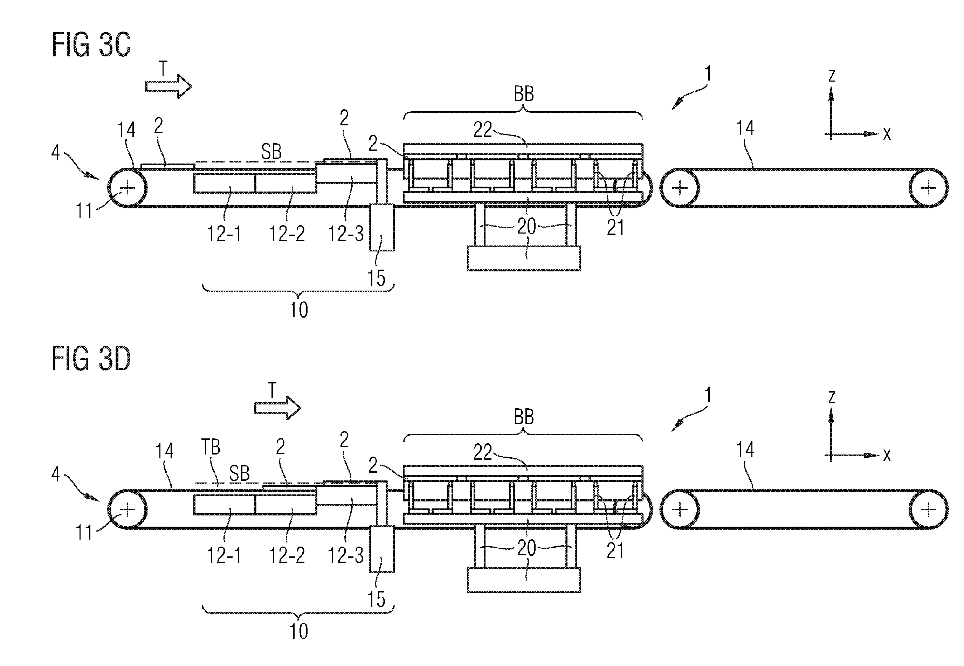

Figur 3C zeigt das erste Substrat 2, nachdem es von dem zugeordneten Segment 12-3 von den Transportriemen 14 der ersten Transporteinrichtung 11 abgehoben und in den Speicherbereich SB transferiert wurde. Gleichzeitig wird ein weiteres Substrat 2 mittels der ersten Transporteinrichtung 11 in der Transportrichtung T transportiert.
Figur 3D zeigt dieses weitere Substrat 2, wie es an einer definierten Position oberhalb des ihm zugeordneten Segments 12-2 gestoppt wird. Hierbei fungierte das in Transportrichtung T nachgelagerte Segment 12-3 als mechanischer Stopper. Dabei dienen die Hubbleche 18 (dargestellt in den Figuren 2A und 2B), welche innerhalb der Transportspur angeordnet sind, als mechanischer Anschlag für das weitere Substrat 2.

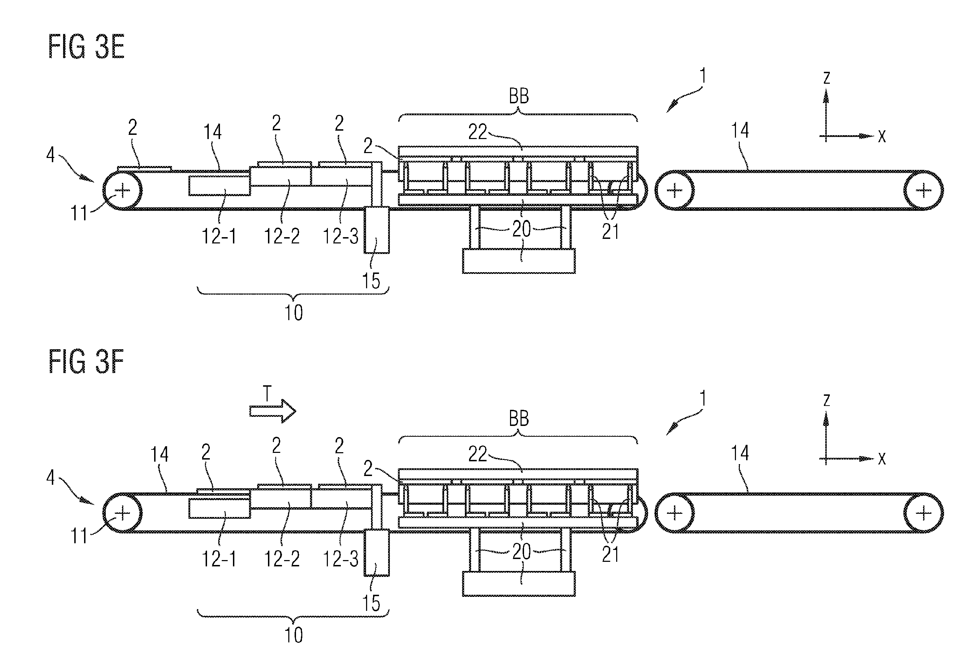

Figur 3E zeigt das zweite Substrat 2, nachdem es mittels des ihm zugeordneten Segments 12-2 von den Transportriemen 14 der ersten Transporteinrichtung 11 abgehoben und in den Speicherbereich der Sammelvorrichtung 10 transferiert wurde. Währenddessen wird mit Hilfe der ersten Transporteinrichtung 11 ein weiteres (drittes) Substrat 2 in Transportrichtung T transportiert.
Figur 3F zeigt dieses dritte Substrat 2 in der ihm zugeordneten Stopp-Position oberhalb des zugeordneten Segments 12-1, wobei wiederum das in Transportrichtung T nachgelagerte Segment 12-2 als mechanischer Stopper fungierte.

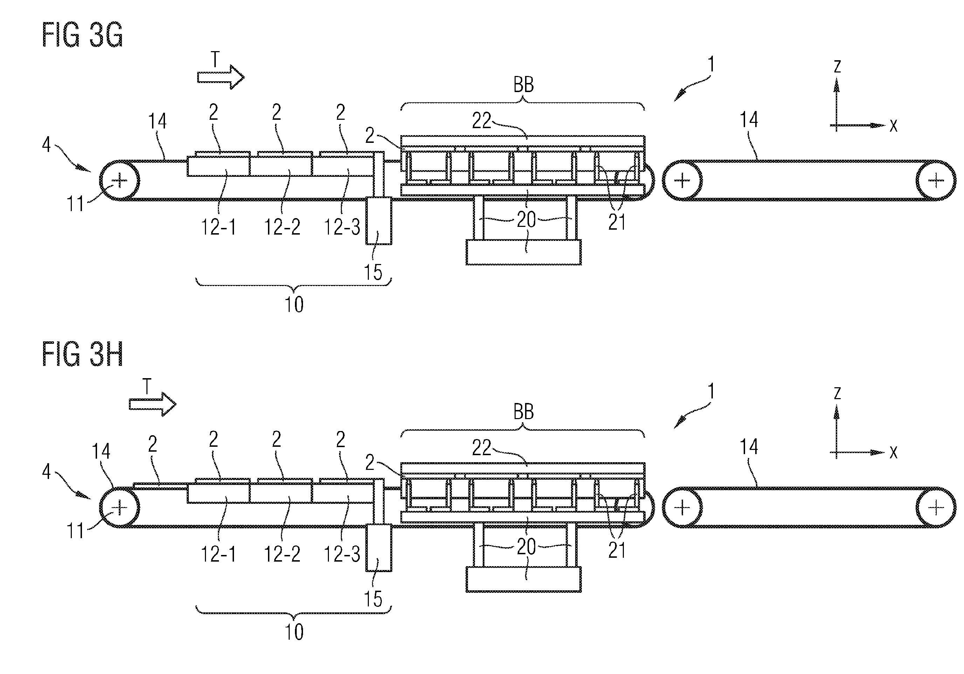

In Figur 3G ist dargestellt, wie auch das dritte Substrat 2 mittels des ihm zugeordneten Segments 12-1 von den Transportriemen 14 der ersten Transporteinrichtung 11 abgehoben und in den Speicherbereich der Sammelvorrichtung 10 transferiert wurde.

In Figur 3H wird ein viertes Substrat 2, welches ebenfalls an einer ihm zugeordneten Stopp-Position gestoppt. Als mechanischer Stopper diente dabei das in Transportrichtung T nachgelagerte Segment 12-1 der Sammelvorrichtung 10. Während des gesamten Sammelvorgangs der vier Substrate 2 (dargestellt in den Figuren 3A bis 3H) werden im Bestückbereich BB des Bestückautomaten 1 weitere Substrate mittels eines Bestückkopfes 6 (siehe Figur 1) mit Bauelementen 3 bestückt.

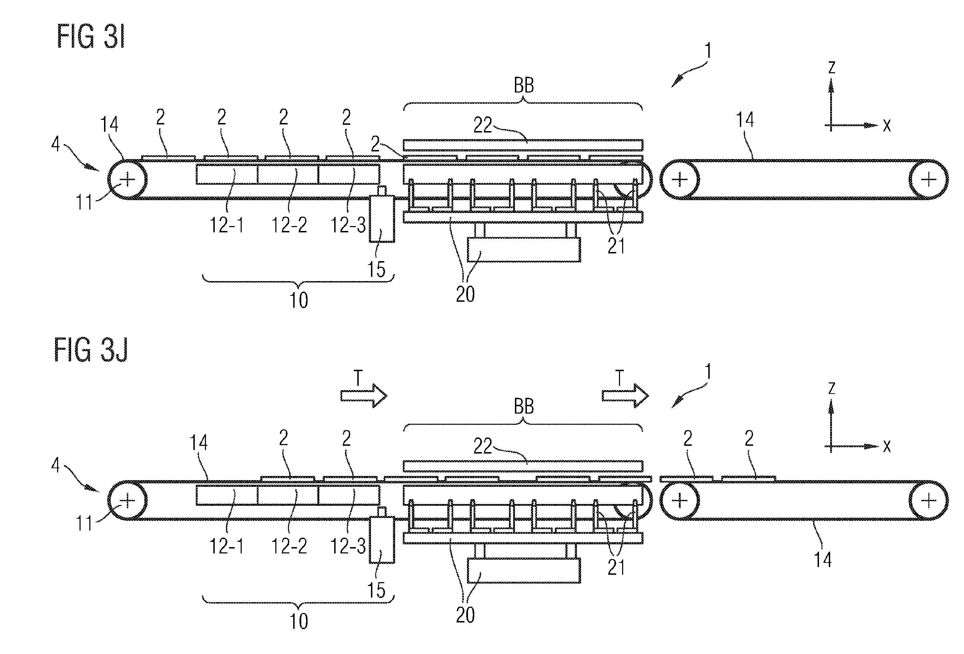

Figur 3I zeigt die Vorrichtung 4 zu einem Zeitpunkt, in dem der Bestückprozess der sich im Bestückbereich BB befindlichen Substrate 2 mit Bauelementen 3 abgeschlossen ist. Der Hubtisch 20 mit dem sich darauf befindlichen Stützstiften 21 ist wieder nach unten gefahren, so dass die sich im Bestückbereich befindlichen Substrate 2 wieder auf den Transportriemen 14 der ersten Transporteinrichtung 11 aufliegen. Vor dem Bestückbereich BB wurden auch die drei Segmente 12-1, 12-2 und 12-3 sowie der Stopper 15 nach unten gefahren. Somit befinden sich vor dem Bestückbereich BB ebenfalls vier Substrate 2 in einem definierten relativen Abstand zueinander auf den Transportriemen 14 der ersten Transporteinrichtung 11.

In Figur 3J ist der Wechsel der Substrate 2 im Bestückbereich BB dargestellt. Mit Hilfe der ersten Transporteinrichtung 11 werden sowohl die vier fertig bestückten Substrate 2 aus dem Bestückbereich BB des Bestückautomaten 1 in x-Richtung heraustransportiert, als auch die vier vor dem Bestückbereich BB gesammelten Substrate 2 in den Bestückbereich BB hineintransportiert.

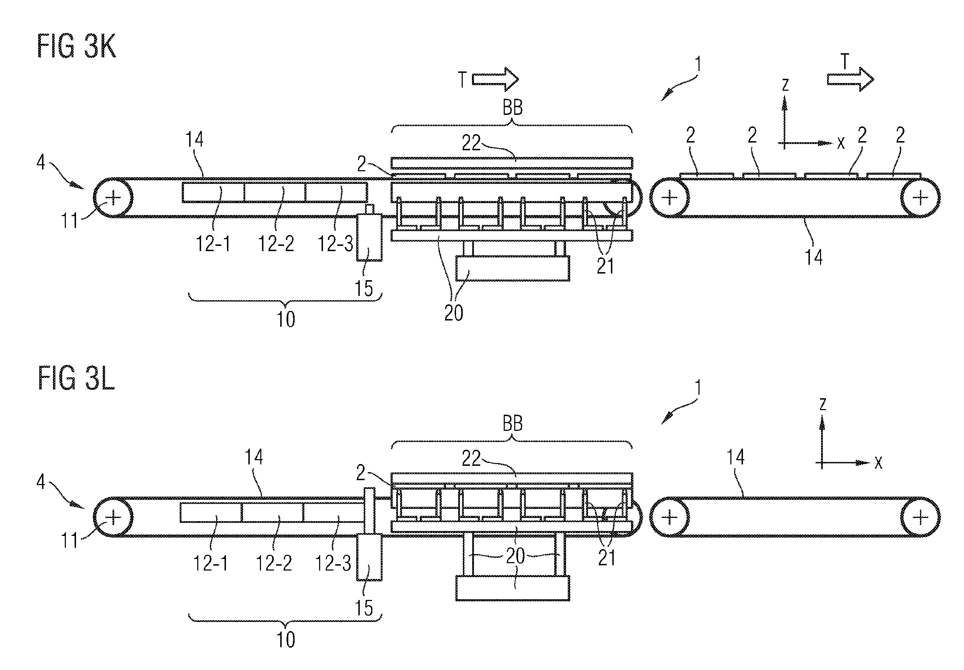

Figur 3K zeigt die Vorrichtung 4 zu einem Zeitpunkt, in dem der Wechsel der vier Substrate im Bestückbereich BB abgeschlossen ist. Die vier fertig bestückten Substrate 2 befinden sich nun auf den Transportriemen 14 des in Transportrichtung T dem Bestückbereich BB nachgelagerten Teiles der ersten Transporteinrichtung 11. Die vier vor dem Bestückbereich BB gesammelten Substrate 2 liegen nun an ihren definierten Positionen auf den Transportriemen 14 innerhalb des Bestückbereichs BB.
Figur 3L zeigt, wie die sich im Bestückbereich BB befindlichen Substrate 2 mit Hilfe des Hubtisches der Stützstifte und des Klemmelements im Bestückbereich fixiert werden. Hierzu wird der Hubtisch 20 mit den sich darauf befindlichen Stützstiften 21 so weit nach oben verfahren, dass die sich im Bestückbereich BB befindlichen Substrate 2 mittels der Stützstifte 21 von unten gegen das Klemmelement 22 geklemmt und fixiert werden.

Weiterhin wurde auch der mechanische Stopper 15 wieder nach oben ausgefahren. Damit können nun wieder weitere Substrate 2 mittels der ersten Transporteinrichtung 11 vor dem Bestückbereich BB mit Hilfe der Sammelvorrichtung 10 gesammelt werden, während gleichzeitig im Bestückbereich BB fixierte Substrate 2 mittels eines Bestückkopfes 6 (siehe Figur 1) des Bestückautomaten 1 bestückt werden.

Die Figuren 4A bis 4H zeigen schematische Seitenansichten einer weiteren Ausbildung der erfindungsgemäßen Vorrichtung in mehreren Verfahrensschritten. Dabei weisen die Abschnitte 12 der Sammelvorrichtung 10 keine Segmente 12 mit zugeordneten zweiten Transporteinrichtungen 13 auf. Zum Stoppen der Substrate 2 an ihren vorbestimmten Stopppositionen ist jedem der Abschnitte 12 eine Stoppeinrichtung 15 zugeordnet, die in den Figuren 4A bis 4K als linear bewegliche, mechanische Stopper 15 dargestellt sind. Die Stopper 15 sind in einem diskreten Raster angeordnet, so dass die gestoppten Substrate 2 in einer vordefinierten, relativen Lage zueinander positioniert werden können. Selbstverständlich ist es möglich, die Lage der einzelnen Stopper 15 und damit das Rastermaß der Anordnung zu variieren.

In Figur 4A ist eine weitere Ausgestaltung der Vorrichtung 4 zum Transport der Substrate 2 in einer Seitenansicht dargestellt. Analog zu den Darstellungen in den Figuren 3A bis 3L weist die Vorrichtung 4 ebenfalls eine erste Transporteinrichtung 11 zum Transport der Substrate 2 in einer Transportrichtung T, sowie mehrere Transportriemen 14 auf, welche als Endlosbänder ausgeführt sind, auf denen die Substrate 2 in ihren Randbereichen aufliegen. Mit Hilfe der ersten Transporteinrichtung 11 können die Substrate 2 zu einer Sammelvorrichtung 10 und weiter in einen Bestückbereich 22 eines Bestückautomaten 1 transportiert werden. Zum exakten Positionieren der Substrate sind im Bestückbereich BB weitere Stoppeinrichtungen 23 vorgesehen. Nachdem die Substrate 2 im Bestückbereich 22 mit Bauelementen 3 (siehe Figur 1) bestückt wurden, werden sie mit Hilfe der ersten Transporteinrichtung 11 wieder aus dem Bestückbereich heraustransportiert.

Die dargestellte Ausführungsform weist dabei drei Abschnitte mit jeweils eigenen Endlosbändern auf, die im Bestückbereich BB sowie in Transportrichtung T betrachtet in den Bereichen vor und nach dem Bestückbereich angeordnet sind. Es ist jedoch ebenfalls möglich, die Endlosbänder derart auszuführen, dass sie sich aus dem Bestückbereich BB auch noch in die Abschnitte davor und/oder danach erstrecken.

Ferner ist im Unterschied zu der in den Figuren 3A bis 3L dargestellten Ausführungsform die Sammelvorrichtung 10, welche in der Transportrichtung T der Substrate ist vor dem Bestückbereich 22 angeordnet ist, mit mehreren Stoppeinrichtungen 15 ausgestattet, welche in diskretem Abstand zueinander angeordnet sind. Dabei ist jedem der Abschnitte 12-1, 12-2 der Sammelvorrichtung 10 genau eine Stoppeinrichtung 15 eindeutig zugeordnet, mittels derer die Substrate 2 an vordefinierten Positionen gestoppt werden, so dass sie eine eindeutig definierbare, relative Lage zueinander einnehmen.

Im Bestückbereich 22 des Bestückautomaten 1 sind analog zu der in den Figuren 3A bis 3L dargestellten Ausführungsform mehrere Stützstifte 21 zum Unterstützen der Substrate 2 während des Bestückens mit Bauelementen 3 (siehe Figur 1)angeordnet. Die Stützstifte 21 sind zu diesem Zweck auf einem Hubtisch 20 positioniert, welcher in einer z-Richtung verfahren werden kann. Gemeinsam mit den Stützstiften 21 werden im vorliegenden Ausführungsbeispiel auch die Transportriemen 14 im Bestückbereich BB in z-Richtung verfahren, so dass die Substrate 2 auf den Transportriemen verbleiben und nicht wie im ersten Ausführungsbeispiel dargestellt von den Riemen abgehoben werden. Dabei werden die Substrate 2 gegen oberhalb der Transportriemen 14 angeordnete Klemmelemente 22 gedrückt und dabei fixiert. Im Fall durchgängiger Endlosbänder, welche nicht nur im Bestückbereich, sondern in den Bereichen davor und/oder danach angeordnet sind, müssen die Substrate 2 von den Transportriemen 14 wie in der in den Figuren 3A bis 3L dargestellten ersten Ausführungsform abgehoben werden.

Anhand der Figurenfolge 4A bis 4H wird im Folgenden eine Ausgestaltung des erfindungsgemäßen Verfahrens näher erläutert:

In Figur 4A befinden sich zwei Substrate 2 im Bestückbereich BB des Bestückautomaten 1. Der Hubtisch 20 ist nach oben verfahren, so dass die Substrate 2 gegen die oberhalb der Transportriemen 14 angeordneten Klemmelemente 22 gedrückt und dabei fixiert werden. Im Bereich des Einlaufbandes, welches in Transportrichtung T vor dem Bestückbereich BB angeordnet ist, sind die beiden Stoppeinrichtungen aktiviert, so dass ankommende Substrate an den jeweiligen Positionen gestoppt werden.

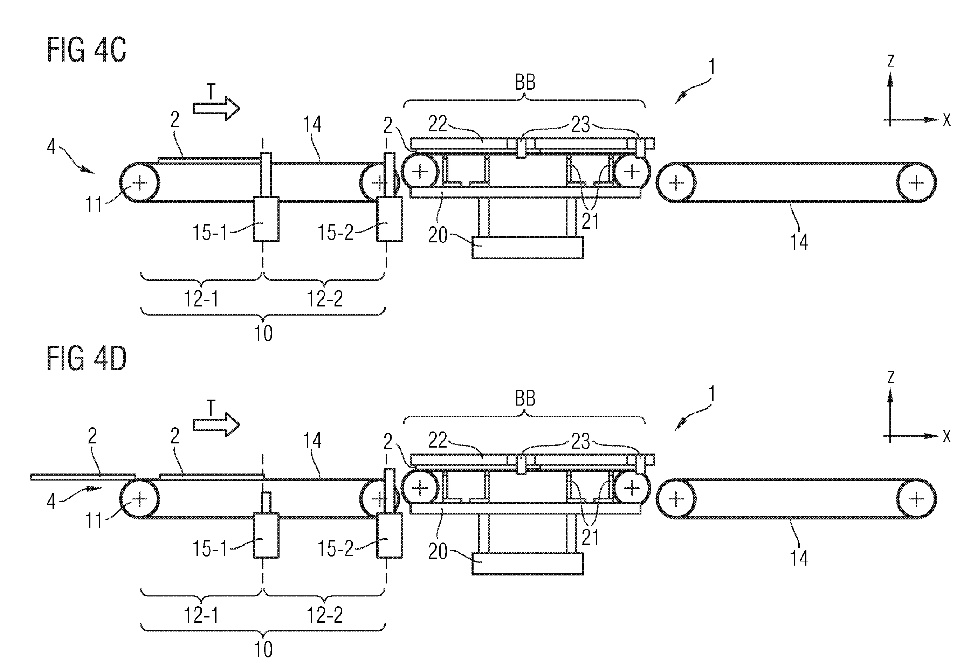

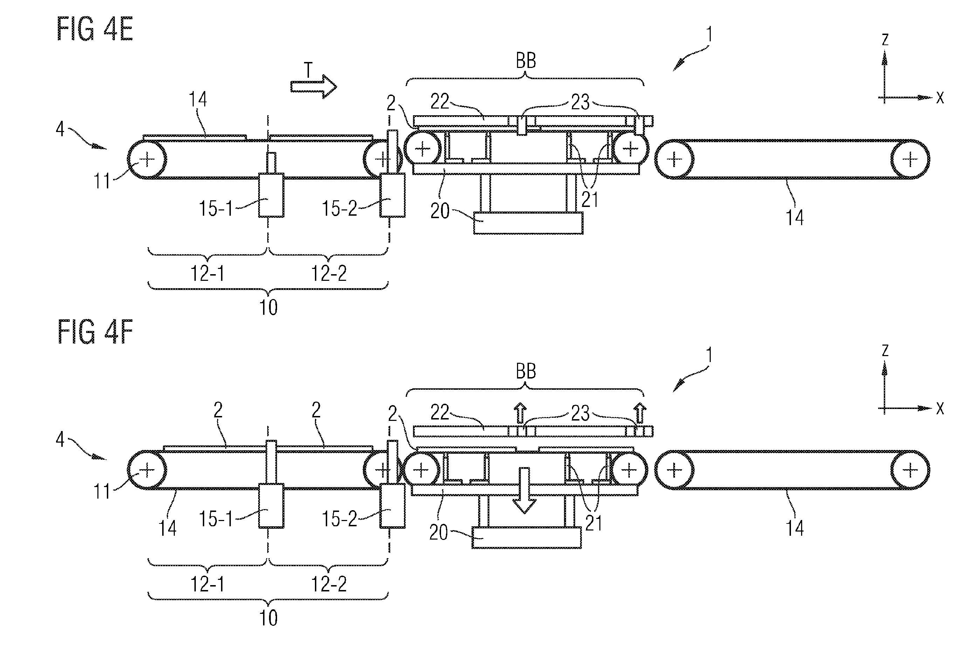

In den Figuren 4B und 4C ist dargestellt, wie ein Substrat 2 im Einlaufbereich auf den Transportriemen 14 transportiert

und schließlich am ersten Stoppelement 15-1 gestoppt wird. Soll ein weiteres Substrat 2 in den Einlaufbereich transportiert werden, so wird die erste Stoppeinrichtung 15-1 deaktiviert, und das erste sowie das weitere Substrat 2 werden voneinander beabstandet gemeinsam mittels der Transportriemen 14 in Transportrichtung T weitertransportiert (siehe Darstellungen in den Figuren 4D und 4E).

Während des Sammelns der Substrate 2, dargestellt in den Figuren 4A bis 4E, können die im Bestückbereich BB positionierten Substrate 2 mit Bauelementen 3 bestückt werden, ohne dass der beschriebene Sammelvorgang die Bestückung beeinflusst.

Hat das erste Substrat 2 die erste Stoppeinrichtung 15-1 passiert, wird diese aktiviert. Anschließend werden die beiden Substrate 2 zum exakten Positionieren in dem ihnen jeweils zugeordneten Abschnitt 12-1 bzw. 12-2 der Sammelvorrichtung 10 gegen die jeweilige Stoppeinrichtung 15-1 bzw. 15-2 gefahren (siehe Figur 4F). Erreicht ein Substrat 2 vor dem anderen seine zugeordnete Stoppposition, so werden die Transportriemen 14, auf denen die Substrate in ihren Randbereichen aufliegen, unter dem einen Substrat 2 durchgezogen, bis auch das andere Substrat 2 seine durch die zugeordnete Stoppeinrichtung definierte Stoppposition erreicht hat.

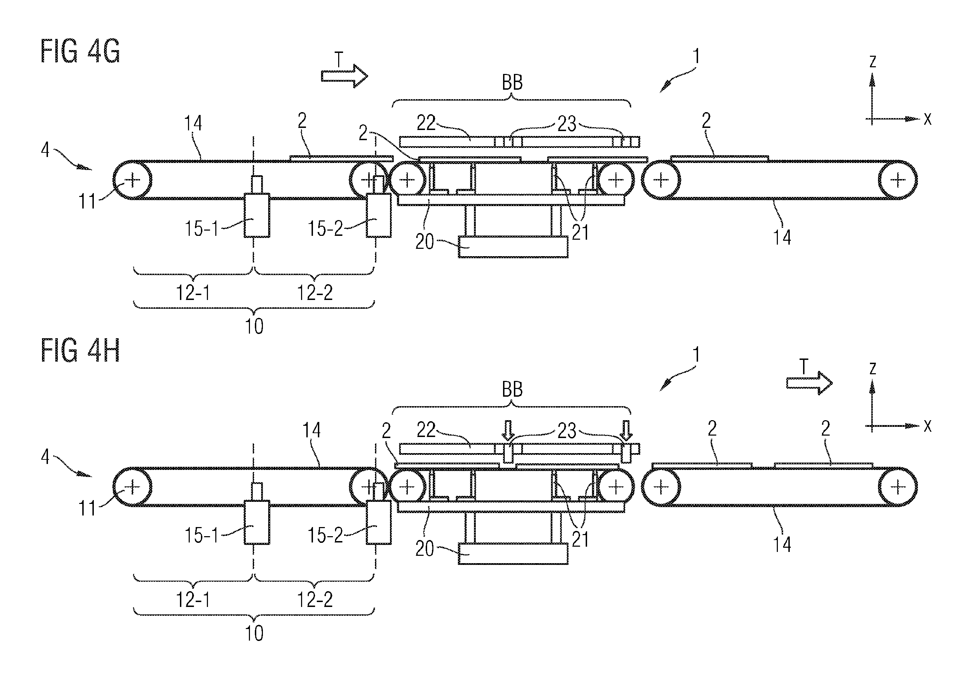

Weiterhin ist in Figur 4 der Bestückvorgang beendet worden. Der Hubtisch 20 ist mit den Stützstiften 21 und den dem Bestückbereich BB zugeordneten Transportriemen 14 in z-Richtung in die Ausgangsstellung zurück verfahren. Alle Transportriemen 15 der ersten Transporteinrichtung 11 befinden sich damit in z-Richtung betrachtet wieder auf demselben Niveau. Darüber hinaus wurden auch die weiteren Stoppeinrichtungen 23 deaktiviert, so dass die beiden bestückten Substrate 2 frei beweglich auf den Transportriemen 15 aufliegen.

In Figur 4G ist der Wechsel der zu bestückenden Substrate 2 dargestellt. Die beiden bestückten Substrate 2 werden mittels der ersten Transporteinrichtung 11 aus dem Bestückbereich BB auf die in Transportrichtung nachfolgend angeordneten Transportriemen 15 transportiert. Gleichzeitig wurden die beiden Stoppeinrichtungen 15-1 und 15-2 deaktiviert, so dass die beiden in den Abschnitten 12-1 und 12-2 der Sammelvorrichtung 10 gespeicherten Substrate 2 in den Bestückbereich BB transportiert werden. Sowohl die beiden bestückten als auch die beiden gespeicherten Substrate 2 behalten dabei ihre ursprüngliche, relative Lage zueinander bei.
Figur 4H zeigt schließlich, wie die beiden zu bestückenden Substrate 2 im Bestückbereich BB exakt positioniert werden. Hierzu werden die beiden weiteren Stoppeinrichtungen 23 aktiviert und stellen somit einen definierten Anschlag für die beiden Substrate 2 dar. Anschließend kann der Hubtisch 20 wieder nach oben verfahren werden, so dass die beiden Substrate im Bestückbereich BB geklemmt werden und bestückt werden können. Die beiden anderen, bereits bestückten Substrate 2 sind vollständig aus dem Bestückbereich BB hinaustransportiert werden und können dem nächsten Bearbeitungsschritt zugeführt werden.

### Bezugszeichenliste

- 1: Bestückautomat
- 2: Substrat
- 3: Bauelement
- 4: Vorrichtung
- 5: Zuführeinrichtung
- 6: Bestückkopf
- 7: Querträger
- 8: Portalarm
- 9: Abholposition
- 10: Sammelvorrichtung
- 11: erste Transporteinrichtung
- 12: Abschnitt / Segment
- 13: zweite Transporteinrichtung
- 14: Transportriemen
- 15: Stoppeinrichtung
- 16: Seitenwange
- 17: Antrieb
- 18: Hubblech

- 20: Hubtisch
- 21: Stützstift
- 22: Klemmelement
- 23: weitere Stoppeinrichtung
- SB: Speicherbereich
- BB: Bestückbereich
- TB: Transportbereich

- T: Transportrichtung

## Patentansprüche

1. Vorrichtung (4) zum Transportieren von Substraten (2) bei einem Bestückautomaten (1),
- mit einer Sammelvorrichtung (10), die zum Sammeln von Substraten (2) ausgebildet ist,
- mit einer ersten Transporteinrichtung (11), die zum Transport der Substrate (2) zur Sammelvorrichtung (10) ausgebildet ist,
- bei der die Sammelvorrichtung (10) zumindest eine Anzahl an Abschnitten (12) zur Aufnahme einer zugeordneten Anzahl an Substraten (2) aufweist, wobei die Abschnitte (12) in einer Transportrichtung (T) der Substrate (2) in diskretem Abstand zueinander aufeinanderfolgend angeordnet sind,
wobei die Substrate (2) mittels der Sammelvorrichtung (10) zueinander in einer relative Lage und in einem diskreten Raster anordenbar sind, und
wobei die Substrate (2) mittels der ersten Transporteinrichtung (11) weitertransportierbar sind, wobei die ursprüngliche relative Lage der Substrate (2) zueinander erhalten bleibt.

2. Vorrichtung (4) nach Anspruch 1, bei der die erste Transporteinrichtung (11) mindestens einen Transportriemen (14) aufweist, welcher zum Transport der Substrate (2) ausgebildet ist.

3. Vorrichtung (4) nach einem der Ansprüche 1 bis 2, bei der jeder Abschnitt (12) genau einem Substrat (2) eindeutig zugeordnet ist.

4. Vorrichtung (4) nach einem der Ansprüche 1 bis 3, bei der jedem der Abschnitte (12) eine Stoppeinrichtung (15) zugeordnet ist, mittels derer die Substrate (2) an einer jeweils vordefinierten Stoppposition positionierbar sind.

5. Vorrichtung (4) nach einem der Ansprüche 1 bis 3,
- bei der jeder Abschnitt (12) eine zweite Transporteinrichtung (13) aufweist, die mit der ersten Transporteinrichtung (11) derart zusammenwirkt, dass durch die zweite Transporteinrichtung (13) die Substrate (2) von der ersten Transporteinrichtung (11) abnehmbar und in einen Speicherbereich (SB) transportierbar sind,
- bei der die zweiten Transporteinrichtungen (13) derart ausgebildet sind, dass eine vorgegebene Anzahl gespeicherter Substrate (2) aus dem Speicherbereich (SB) auf die erste Transporteinrichtung (11) rückführbar sind, um gemeinsam weitertransportiert zu werden.

6. Vorrichtung (4) nach Anspruch 5, bei der die zweite Transporteinrichtung (13) zur geradlinigen Bewegung längs einer Achse ausgebildet ist.

7. Vorrichtung (4) nach einem der Ansprüche 5 bis 6, bei der die zweite Transporteinrichtung (13) als mindestens ein Hubblech (18) ausgebildet ist, welches derart mit der ersten Transporteinrichtung (11) zusammenwirkt, dass Substrate (2) in den Speicherbereich (SB) verbringbar sind.

8. Vorrichtung (4) nach einem der Ansprüche 5 bis 7, bei der die zweiten Transporteinrichtungen (13) mehrerer Abschnitte (12) hinsichtlich ihres Bewegungsablaufs gekoppelt sind und gemeinsam einem Substrat (2) eindeutig zugeordnet sind.

9. Vorrichtung (4) nach einem der Ansprüche 5 bis 8, welche mindestens eine Stoppeinrichtung (15) aufweist, mittels derer das Substrat (2) vor dem Abnehmen des Substrats (2) von der ersten Transporteinrichtung (11) an einer vordefinierten Stoppposition positionierbar ist.

10. Vorrichtung (4) nach Anspruch 9, bei der die mindestens eine Stoppeinrichtung (15) als mindestens ein mechanischer Stopper ausgebildet ist.

11. Vorrichtung (4) nach Anspruch 10, bei der die zweite Transporteinrichtung (13) eines Abschnitts (12-2) als mechanischer Stopper für den in Transportrichtung (T) vorgelagerten Abschnitt (12-1) einsetzbar ist.

12. Vorrichtung (4) nach Anspruch 9, bei der die Stoppeinrichtung (15) als Sensor ausgebildet ist, welcher ein Substrat (2) registriert und mit einer Steuereinheit der Vorrichtung (4) gekoppelt ist, so dass die erste Transporteinrichtung (11) derart steuerbar ist, dass das Substrat (2) an der vordefinierten Stoppposition positionierbar ist.

13. Vorrichtung (4) nach einem der Ansprüche 1 bis 12, bei welcher in Transportrichtung (T) nach der Sammeleinrichtung (10) ein Bestückbereich (BB) angeordnet ist, in den die Substrate (2) nach dem Sammeln gemeinsam transportiert werden.

14. Vorrichtung (4) nach Anspruch 13,
wobei sich im Bestückbereich (BB) befindliche Substrate (2) mit Bauelementen (3) bestückbar sind, während weitere Substrate (2) transportiert und vor dem Bestückbereich (BB) mittels der Sammelvorrichtung (10) gesammelt werden.

15. Bestückautomat (1) zum Bestücken von Substraten (2) mit Bauelementen (3),
- mit einer Vorrichtung (4) zum Transportieren der Substrate (2) nach einem der Ansprüche 1 bis 14,
- mit einem Bestückbereich (BB), in dem die Substrate (2) bestückt werden,
- bei dem die Vorrichtung (4) in einer Transportrichtung (T) der Substrate (2) zumindest teilweise vor dem Bestückbereich (BB) angeordnet ist.

16. Bestückautomat (1) nach Anspruch 15, welcher mehrere Bestückbereiche (BB) aufweist,
wobei auch zwischen den Bestückbereichen (BB) eine Vorrichtung (4) zum Transportieren der Substrate (2) vorgesehen ist.

17. Verfahren zum Transportieren von Substraten (2) bei einem Bestückautomaten (1),
- bei dem in einem ersten Verfahrensschritt Substrate (2) mittels einer ersten Transporteinrichtung (11) zu einer Sammelvorrichtung (10) transportiert werden,
- bei der in einem zweiten Verfahrensschritt die Substrate (2) an vordefinierten Positionen eines Transportbereichs (TB), welche in diskretem Abstand zueinander angeordnet sind, gestoppt werden, so dass die Substrate (2) eine definierte relative Lage zueinander aufweisen,
- bei dem in einem dritten Verfahrensschritt eine vorbestimmte Anzahl an gespeicherten Substraten (2) mittels der ersten Transporteinrichtung (11) gemeinsam aus dem Transportbereich (TB) in einen Bestückbereich (BB) weitertransportiert werden, wobei die ursprüngliche relative Lage der Substrate (2) zueinander erhalten bleibt.

18. Verfahren nach Anspruch 17,
- bei dem vor dem Weitertransport der Substrate (2) in den Bestückbereich (BB) die Substrate (2) aus dem Transportbereich (TB) in einen Speicherbereich (SB) verbracht und dort gesammelt werden,
- bei dem in einem darauffolgenden Verfahrensschritt die gespeicherten Substrate (2) aus dem Speicherbereich (SB) wieder in den Transportbereich (TB) gebracht werden.

19. Verfahren nach Anspruch 18,
- bei dem vor dem Weitertransport der Substrate (2) in den Bestückbereich (BB) ein weiteres Substrat (2) im Transportbereich (TB) an einer weiteren Position gestoppt wird,
- so dass die Substrate (2) aus dem Speicherbereich (SB) zusammen mit dem weiteren Substrat (2) gemeinsam weitertransportiert werden.

20. Verfahren nach Anspruch 18 oder 19, bei der die Substrate (2) mit Hilfe zugeordneter, die Abschnitte (12) bildender Segmente, die in einer Substrat-Transportrichtung (T) aufeinander folgen, durch eine Hubbewegung aus dem Transportbereich (TB) in den Speicherbereich (SB) gebracht werden.

21. Verfahren nach Anspruch 20, bei dem jedes der Substrate (2) mit jeweils einem zugeordneten Segment (12) transportiert wird.

22. Verfahren nach Anspruch 20, bei dem ein Bewegungsablauf mehrerer Segmente (12) gekoppelt erfolgt, um ein Substrat (2) aus dem Transportbereich (TB) in den Speicherbereich (SB) zu bringen.

23. Verfahren nach einem der Ansprüche 17 bis 22,
- bei dem die Substrate (2) gemeinsam in einen Bestückbereich (BB) eines Bestückautomaten (1) transportiert werden, um dort mit Bauelementen (3) bestückt zu werden,
- bei dem während der Bestückung der Substrate (2) weitere Substrate (2) vor dem Bestückbereich (BB) gesammelt werden.
